# EUROPEAN PATENT SPECIFICATION

(11) **EP 4 089 790 B1**
(45) Date of publication and mention of the grant of the patent: **20.12.2023**
(21) Application number: 21173285.4
(22) Date of filing: 11.05.2021
(51) Int. Cl.: H01M 10/48, H01M 50/528, H01M 50/545, H01M 50/569, G01K 7/22, G01R 31/364

(54) **BATTERY CELL AND BATTERY SYSTEM COMPRISING A BATTERY CELL**
BATTERIEZELLE UND BATTERIESYSTEM MIT EINER BATTERIEZELLE
CELLULE DE BATTERIE ET SYSTÈME DE BATTERIE COMPRENANT UNE CELLULE DE BATTERIE

(43) Date of publication of application: 16.11.2022
(73) Proprietor: Samsung SDI Co., Ltd., Yongin-si, Gyeonggi-do 17084 (KR)
(72) Inventor: Reinprecht, Wolfgang, 8144 Attendorf (AT); Haring, Fritz, 8600 Bruck / Mur (AT)
(74) Representative: Gulde & Partner

(56) References cited:
- DE-A1-102014 212 290

## Description

### Field of the Disclosure

The present disclosure relates to a battery cell for a battery, in particular a traction battery of an electric vehicle, which allows for a particularly simple temperature and cell voltage measurement. Further, the present invention relates to a battery system comprising a plurality of such battery cells and a vehicle comprising such a battery system.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery, EVB, or traction battery is a battery used to power the propulsion of battery electric vehicles, BEVs. Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

Battery modules can be constructed either in block design or in modular design. In block designs each battery is coupled to a common current collector structure and a common battery management system and the unit thereof is arranged in a housing. In modular designs, pluralities of battery cells are connected to form submodules and several submodules are connected to form the battery module. In automotive applications, battery systems often consist of a plurality of battery modules connected in series for providing a desired voltage. Therein, the battery modules may comprise submodules with a plurality of stacked battery cells, each stack comprising cells connected in parallel that are connected in series (*XpYs*) or multiple cells connected in series that are connected in parallel (*XsYp*)*.*

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually comprise a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS/BMU is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further comprise a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

To provide thermal control of the battery pack a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable deteriorates and the life-span of the rechargeable battery is shortened. Thus, cell cooling for effectively emitting/discharging/dissipating heat from the cells is required.

Thus, the monitoring of the voltage and the temperature of each individual battery cell is required to operate the battery cell and therefore the battery system in an optimum as well as in a safe state. As mentioned above, the BMMs may measure the individual cell voltages and temperatures of the battery cells in a battery system. For the measurement of the cell voltage of a battery cell an electric cable is usually connected to the positive electrode of the battery cell and another such cable to the negative electrode of the battery cell. For the measurement of the temperature of the battery cell, on the other hand, a temperature sensor is attached to an outer surface of the battery cell and connected to the cell via two cables. Such measurement arrangements are complex.

DE 10 2016 208 066 A1 and DE 10 2014 212 290 A1 each describe a temperature dependent resistive device as a temperature sensor for determining the temperature of a battery cell.

It is thus an object of the present disclosure to overcome or reduce at least some of the drawbacks of the prior art and to provide a battery cell and battery system that allow for a less complex and more reliable battery cell voltage and temperature measurement.

### Summary of Invention

Embodiments of the present disclosure seek to solve at least one of the problems existing in the prior art to at least some extent.

According to the invention, a battery cell is provided as defined in claim 1.

In particular, a battery cell for a battery system of a vehicle (in particular an electric vehicle) is provided, the battery cell comprising a cell housing encompassing an electrochemical cell, a positive electrode and a negative electrode forming cell terminals, the battery cell further comprising a thermistor integrated into the battery cell and electrically interconnecting the cell housing with at least one of the cell terminals, and a connecting means electrically connected to the cell housing to determine an inside temperature of the battery cell.

The battery cell comprises an electrochemical cell arranged in the cell housing, the electrochemical cell being capable of discharging by generating electrical energy from chemical reactions and charging by using electrical energy to cause chemical reactions. The housing can protect the electrochemical cell with respect to its surroundings and can hold an electrolyte. Via the cell terminals the battery cell can provide an electrical output to a battery system comprising further battery cells. As mentioned above, the positive electrode, the negative electrode, and a separator interposed between the positive and negative electrodes may form an electrode assembly. The cell housing may be considered a case receiving the electrode assembly and the electrolyte. The battery cells can be interconnected with one another via their cell terminals.

The thermistor is arranged to determine an inside temperature or cell temperature of the battery cell, i.e. a temperature inside the cell housing and/or inside the electrochemical cell. The thermistor may be a NTC (negative temperature coefficient) thermistor or a PTC (positive temperature coefficient) thermistor. The thermistor may be a thermistor from Ruhstrat Power Technology (RPT) company. The thermistor is a temperature dependent resistive device. Thus, to measure the electrical resistance of the thermistor a current may be applied as a test current to the thermistor via the cell terminal the thermistor is connected to and via the connecting means. Thus, the electrical connecting means may be connected to the thermistor via the cell housing. The connecting means may comprise an electrical wire, in particular a single electrical wire only as will be explained later. Applying different load currents on the thermistor will cause a voltage drop at the connecting means which allows to calculate the resistance of the thermistor and further the temperature of the battery cell. The design of the thermistor can be optimized in such a way that a high sensitivity of the temperature behavior is provided between an allowed temperature operating range and a critical over temperature range. Furthermore, the polarity of the test current can be changed to get more accurate measurement results. In particular, either a sink current, i.e. voltage less at the connecting means than at the cell terminal, or a source current, i.e. voltage higher at the connecting means than at the cell terminal, can be applied. Also, a test with no current, i.e. an idle state, may be done.

Via the connecting means not only the temperature (in cooperation with the thermistor) but also the cell voltage may be measured. This may be done by determining an electric potential at the connecting means and an electric potential at the cell terminal not being connected to the thermistor and comparing these two potentials, as explained below. Thus, a voltage may be tapped at the connecting means. Thus, thanks to the inventive arrangement of the thermistor it is no longer necessary to provide two separate measurement devices, one for measuring the cell voltage and the other for measuring the cell temperature as explained above. As a result, the inventive measurement arrangement is less complex.

Due to the inventive arrangement of the thermistor a high impedance resistance is provided between the cell housing and the cell terminal the thermistor is connected to, which is in particular the positive electrode. Further, by interconnecting the cell housing with the respective cell terminal via the thermistor the cell housing is biased to the voltage provided by the respective cell terminal. In particular, by interconnecting the cell housing with the positive electrode via the thermistor the cell housing is biased to the most positive voltage provided by the positive electrode. This results in multiple advantages.

First of all, the inside temperature of the battery cell can be measured easily and reliably by applying a load current via the cell terminal the thermistor is connected to and via the connecting means as explained above. The thermistor changes its electrical resistance with a change in temperature which can be electrically measured and wherefrom the cell temperature can be derived. Thus, the cell temperature can be monitored and, if necessary, measures can be taken to ensure the proper working of the battery cell.

Furthermore, a short circuit of neighboring cell housings does not negatively affect the battery cell. In particular does such a short circuit not cause a high current between the neighboring battery cells thanks to the thermistor being electrically connected to the cell housing. The thermistor having a high impedance is of particular benefit in this case. Also, handling of the battery cell prior to its placement for the intended use in a battery system is less critical because short circuits between the cell housing and the cell terminal are prevented by the thermistor. This is of particular relevance when the thermistor is connected to the positive electrode, and preferably only with the positive electrode, as short circuits between the cell housing and the positive electrode are more critical than short circuits between the cell housing and the negative electrode.

Finally, such short circuits as mentioned above, which may e.g. be the result of isolation defects of the cell housing to a chassis of an electric vehicle carrying the battery cell/system or to neighboring cells, cause a significant voltage change on the electrical connecting means and therefore support early detection of battery fails. In this manner, the isolation of the battery cell can be tested. Thus, the inventive connection of the connecting means and the thermistor to the cell housing allows for a simple and cost-effective monitoring not only of the cell temperature but also of the cell voltage and in particular the isolation of the battery cell. Isolation defects may be defects in an electrical insulation of the respective component, in particular of the cell housing.

According to the invention the thermistor is integrated into the battery cell. In particular, the thermistor may be arranged inside the cell housing. The thermistor may be integrated as such while manufacturing the battery cell. The connecting element connecting the thermistor to the respective cell terminal and the cell housing may thus be integrated into the battery cell as well, in particular arranged inside the cell housing. Temperature measurements via such an integrated thermistor may be particularly reliable because the thermistor itself and its connecting elements are protected from environmental influences.

According to an embodiment the thermistor electrically interconnects the cell housing with the positive electrode, in particular only with the positive electrode, to measure the inside temperature of the battery cell. Connecting the thermistor to the positive electrode is particularly useful as this allows for the explained temperature measurement of the battery cell while protecting the battery cell particularly effective from short circuits. As mentioned above, short circuits between the cell housing and the positive electrode are more critical than short circuits between the cell housing and the negative electrode. Thanks to such a thermistor arrangement short circuits in the battery cell do not cause a high current between the positive electrode and the cell housing thereby protecting the battery cell effectively. It may suffice in this regard to electrically connect the thermistor with the cell housing and the positive electrode only. In particular, a connection between the thermistor and the negative electrode may be omitted as short circuits between the cell housing and the negative electrode are less critical. This would further reduce the complexity.

According to an embodiment the connecting means comprise a single wire. In other words, only one single electrical wire may be connected to the cell housing so that above-mentioned load/test current for the temperature measurement is applied to the thermistor via the single wire and the respective cell terminal. The single wire may be understood to form a single wire interface, the interface not only allowing for determining the cell temperature via the thermistor but also to measure the cell voltage. In the state of the art, cell voltage and temperature measurement of batteries is done using separate signal wires from a sensor or cell terminal to the measuring circuit as mentioned above. This requires multiple wires and therefore a wider Flex connector to contain all signals. Further, the temperature sensors have to be attached to the housing of the cell, which is an additional production process and produces costs. The connecting means comprising only a single electrical wire is a particularly simple embodiment. With the connecting means comprising only a single wire the costs are reduced, in particular because the cell voltage can be measured through the same single wire interface that is used for the temperature determination via the thermistor. Also, short circuits cause a particularly significant voltage change on the single wire interface and thus support early detection of battery fails.

According to another aspect of the present disclosure, a battery system for an electric vehicle is provided, the battery system comprising a high voltage battery with a plurality of battery cells interconnected with one another via their cell terminals. At least one of the battery cells is adapted as explained above. Preferably multiple and more preferably all of the battery cells of the battery system are adapted as explained above. A battery system comprising the inventive battery cells has the above explained advantages. Thus, the battery system may be adapted to measure the temperatures and/or cell voltages of its battery cells as explained above. In particular, the BMS and/or one or more BMMs may be adapted to measure the individual cell voltages and temperatures of the battery cells. The battery system, in particular the BMS and/or one or more BMMs, may be adapted as explained in the following.

According to an embodiment the battery system is adapted to measure an inside temperature of at least one of the battery cells by applying a current through the thermistor via the cell terminal the thermistor is connected to and the connecting means, measuring the voltage drop across the thermistor, determining the resistance of the thermistor from the voltage drop, determining the temperature based on the determined resistance. Thus, the temperature of one or more of the battery cells of the battery system may be determined as explained above with respect to the battery cell.

According to an embodiment the battery system is adapted to measure a cell voltage of at least one of the battery cells via the connecting means, in particular by comparing an electrical potential of the connecting means, and thus the housing, with an electrical potential of the positive and/or negative electrode of the battery cell. The cell voltage may be determined preferably by comparing he electrical potential of the connecting means with the electrical potential the cell terminal not being connected to the thermistor. For example, if the thermistor is connected to the positive electrode, the cell voltage may be measured by tapping the voltage between the connecting means and the positive electrode. Thus, the cell voltage of one or more of the battery cells of the battery system may be determined as explained above with respect to the battery cell.

According to an embodiment the battery system is adapted to determine whether a short circuit within the battery system has occurred by monitoring the potentials of the cell housings of the plurality of battery cells via their respective connecting means. Thus, the occurrence of an isolation error of one or more of the battery cells of the battery system may be determined as explained above with respect to the battery cell.

According to another aspect of the present disclosure, a vehicle including a battery system as defined above is provided.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a schematic side view of a battery cell according to an embodiment,
- Fig. 2: illustrates a top view of a battery system comprising multiple battery cells.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, an upper end of the cell housing is positioned at the upper part of the z-axis, whereas a lower end of the cell housing is positioned at the lower part of the z-axis. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

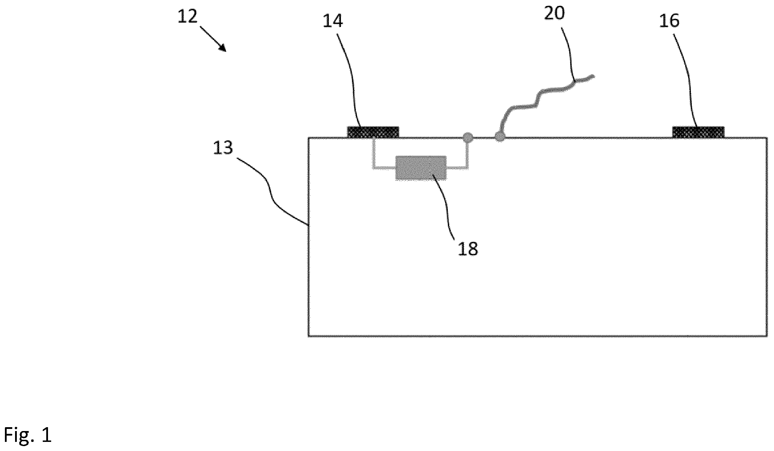

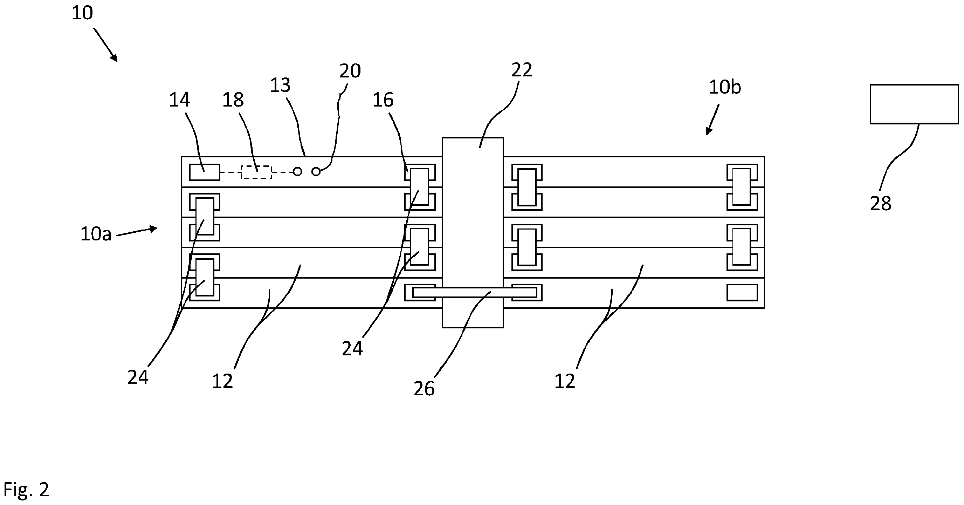

Fig. 1 is a side view illustrating a battery cell 12 according to an embodiment, the battery cell 12 comprising a cell housing 13 encompassing an electrochemical cell (not shown), a positive electrode 14 and a negative electrode 16. The positive electrode 14 and the negative electrode 16 form cell terminals via which the battery cell 12 may be connected to further such battery cells as can be seen in Fig. 2. In a battery system 10 for an electric vehicle multiple of such battery cells 12 may be interconnected via their respective cell terminals 14, 16 via busbars 24, 26 to form battery modules.

This can be seen in Fig. 2 where a first battery module 10a is formed by five battery cells 12 and a second battery module 10b is formed by further five battery cells 12, the battery modules 10a, 10b being separated from one another via a crossbeam 22. Busbars 24 interconnect adjacent battery cells 12 by contacting their respective cell terminals 14, 16 and busbar 26 interconnects the modules 10a, 10b by expanding above the crossbeam 22 and contacting the cell terminals 14, 16 of battery cells of the different modules 10a, 10b. The modules 10a, 10b can, of course, comprise more or less than five battery cells each. Also, further battery modules may be provided. For reasons of clarity not all of the elements in Fig. 2 have been provided with reference signs.

The battery cell 12 of Fig. 1 further comprises a thermistor 18 integrated into the cell housing 13, the thermistor 18 being electrically connected to the cell housing 13 and to the positive electrode 14. In this manner the thermistor 18 interconnects the cell housing 13 and the positive electrode 14. Further, a single wire 20 is provided as a connecting means, the single wire 20 being electrically connected to the cell housing 13. Vie the cell housing 13 the thermistor 18 is connected with the single wire 20.

The thermistor 18, the cell terminals 14, 16 and the single wire 20 form a measurement arrangement that allows to determine an inside temperature of the battery cell 12 as well as a cell voltage.

An inside temperature of the battery cell 12 may be measured by applying a current through the thermistor 18 via the positive electrode 14 and the single wire 20, measuring a voltage drop across the thermistor 18, determining the resistance of the thermistor 18 from the voltage drop, and determining the temperature of the battery cell 12 based on the determined resistance.

A cell voltage of the battery cell 12 may be measured via the single wire 20 by comparing an electrical potential of the single wire 20 with an electrical potential of the negative electrode 16.

The thermistor 18 provides a high impedance resistance between the cell housing 13 and the positive electrode 14. Further, by interconnecting the cell housing 13 with the positive electrode 14 via the thermistor 18 the cell housing is biased to the voltage provided by the positive electrode 14.

As a result, a short circuit of neighboring cell housings does not negatively affect the battery cell as such a short circuit does not cause a high current between the neighboring battery cells. Also, short circuits between the cell housing 13 and the positive electrode 14 that might damage the cell are prevented by the thermistor. Also, such short circuits as mentioned above cause a significant voltage change on the single wire 20 and therefore support early detection of battery fails. In this manner, the isolation of the battery cell can be tested. Thus, it may be determined whether a short circuit within the battery cell 12 has occurred by monitoring the potential of the cell housing 13 via the single wire 20.

Thus, the inventive connection of the single wire 20 and the thermistor 18 to the cell housing 13 allows for a more simple and cost-effective monitoring not only of the cell temperature but also of the cell voltage and further of the isolation of the battery cell compared to the state of the art which uses separate signal wires from a sensor or cell terminal to the measuring circuit. The electrical connecting means comprising only a single wire 20 is particularly simple and cost-effective.

Accordingly, the battery system 10 is adapted to measure the inside temperature of at least one of the battery cells 12 by applying a current through the thermistor 18 via the cell terminal 14 and the single wire 20, by measuring the voltage drop across the thermistor 18, by determining the resistance of the thermistor 18 from the voltage drop, and determining the temperature based on the determined resistance. The battery system 10 is further adapted to measure a cell voltage of at least one of the battery cells 12 via the single wire 20.

The further battery cells 12 of the battery system 10 of Fig. 2 preferably comprise such a single wire 20 and a thermistor 18 as well, the single wire 20 being connected to the respective cell terminal, in particular the respective positive electrode. The battery system 10 is adapted to determine whether a short circuit within the battery system 10 has occurred by monitoring the potentials of the cell housings 13 of the plurality of battery cells 12 via their respective connecting means 20.

The battery system 10 may comprise a control unit 28 for executing the above-mentioned steps.

### Reference signs

- 10: battery system
- 10a: first module
- 10b: second module
- 12: battery cell(s)
- 13: cell housing
- 14: positive electrode
- 16: negative electrode
- 18: thermistor
- 20: single wire
- 22: crossbeam
- 24: busbars
- 26: busbar
- 28: control unit

## Claims

1. A battery cell (12) for a battery system (10), comprising a cell housing (13) encompassing an electrochemical cell, a positive electrode (14) and a negative electrode (16) forming cell terminals (14, 16), the battery cell (12) further comprising a thermistor (18) integrated into the battery cell (12) and electrically interconnecting the cell housing (13) with at least one of the cell terminals (14, 16), and a connecting means (20) electrically connected to the cell housing (13) to determine an inside temperature of the battery cell (12).

2. The battery cell (12) of claim 1, **characterized in that** the thermistor (18) electrically interconnects the cell housing (13) with the positive electrode (14), in particular only with the positive electrode (14), the thermistor (18) being adapted to measure the inside temperature of the battery cell (12).

3. The battery cell (12) of one of the preceding claims, **characterized in that** the connecting means (20) comprise a single wire (20).

4. A battery system, comprising a high voltage battery with a plurality of battery cells (12) according to one of the preceding claims interconnected with one another via their cell terminals (14, 16).

5. The battery system (10) of claim 4, wherein the battery system comprises means adapted to measure an inside temperature of at least one of the battery cells (12) by applying, via means for applying a current, a current through the thermistor (18) via the cell terminal (14) the thermistor (18) is connected to and the connecting means (20), the battery system comprising means for measuring the voltage drop across the thermistor (18), determining the resistance of the thermistor (18) from the voltage drop, determining the temperature based on the determined resistance.

6. The battery system (10) of claim 4 or 5, wherein the battery system (10) comprises means adapted to measure a cell voltage of at least one of the battery cells (12) via the connecting means (20).

7. The battery system (10) of one of claims 4 to 6, wherein the battery system (10) comprises means adapted to determine whether a short circuit within the battery system (10) has occurred by monitoring, via means for monitoring, the potentials of the cell housings (13) of the plurality of battery cells (12) via their respective connecting means (20).

8. An electric vehicle comprising a battery system (10) of any one of claims 4 to 7.

## Patentansprüche

1. Batteriezelle (12) für ein Batteriesystem (10), umfassend ein Zellengehäuse (13), das eine elektrochemische Zelle, eine positive Elektrode (14) und eine negative Elektrode (16), die Zellenanschlüsse (14, 16) bilden, umschließt, wobei die Batteriezelle (12) ferner einen Thermistor (18), der in die Batteriezelle (12) integriert ist und das Zellengehäuse (13) mit mindestens einem der Zellenanschlüsse (14, 16) elektrisch verbindet, und ein Verbindungsmittel (20), das elektrisch mit dem Zellengehäuse (13) verbunden ist, um eine Innentemperatur der Batteriezelle (12) zu bestimmen, umfasst.

2. Batteriezelle (12) nach Anspruch 1, **dadurch gekennzeichnet, dass** der Thermistor (18) das Zellengehäuse (13) mit der positiven Elektrode (14), insbesondere nur mit der positiven Elektrode (14), elektrisch verbindet, wobei der Thermistor (18) zur Messung der Innentemperatur der Batteriezelle (12) ausgebildet ist.

3. Batteriezelle (12) nach einem der vorhergehenden Ansprüche, **dadurch gekennzeichnet, dass** die Verbindungsmittel (20) einen einzigen Draht (20) aufweisen.

4. Batteriesystem, umfassend eine Hochspannungsbatterie mit einer Vielzahl von Batteriezellen (12) nach einem der vorhergehenden Ansprüche, die über ihre Zellenanschlüsse (14, 16) miteinander verbunden sind.

5. Batteriesystem (10) nach Anspruch 4, wobei das Batteriesystem Mittel umfasst, die geeignet sind, eine Innentemperatur von mindestens einer der Batteriezellen (12) zu messen, indem über Mittel zum Anlegen eines Stroms ein Strom durch den Thermistor (18) über den Zellenanschluss (14), mit dem der Thermistor (18) verbunden ist, und die Verbindungsmittel (20) angelegt wird, wobei das Batteriesystem Mittel zum Messen des Spannungsabfalls über dem Thermistor (18), zum Bestimmen des Widerstands des Thermistors (18) aus dem Spannungsabfall und zum Bestimmen der Temperatur auf der Grundlage des bestimmten Widerstands umfasst.

6. Batteriesystem (10) nach Anspruch 4 oder 5, wobei das Batteriesystem (10) Mittel umfasst, die geeignet sind, eine Zellenspannung von mindestens einer der Batteriezellen (12) über die Verbindungsmittel (20) zu messen.

7. Batteriesystem (10) nach einem der Ansprüche 4 bis 6, wobei das Batteriesystem (10) Mittel umfasst, die geeignet sind, um zu bestimmen, ob ein Kurzschluss innerhalb des Batteriesystems (10) aufgetreten ist, indem sie über Mittel zur Überwachung die Potentiale der Zellengehäuse (13) der Vielzahl der Batteriezellen (12) über ihre jeweiligen Verbindungsmittel (20) überwachen.

8. Elektrofahrzeug mit einem Batteriesystem (10) nach einem der Ansprüche 4 bis 7.

## Revendications

1. Cellule de batterie (12) pour un système de batterie (10), comprenant un boîtier de cellule (13) entourant une cellule électrochimique, une électrode positive (14) et une électrode négative (16) formant des bornes de cellule (14, 16), la cellule de batterie (12) comprenant en outre une thermistance (18) intégrée à la cellule de batterie (12) et interconnectant électriquement le boîtier de cellule (13) à au moins l'une des bornes de cellule (14, 16), et un moyen de connexion (20) électriquement connecté au boîtier de cellule (13) pour déterminer une température intérieure de la cellule de batterie (12).

2. Cellule de batterie (12) selon la revendication 1, **caractérisée en ce que** la thermistance (18) interconnecte électriquement le boîtier de cellule (13) à l'électrode positive (14), en particulier uniquement à l'électrode positive (14), la thermistance (18) étant adaptée pour mesurer la température intérieure de la cellule de batterie (12).

3. Cellule de batterie (12) selon l'une des revendications précédentes, **caractérisée en ce que** le moyen de connexion (20) comprend un fil unique (20).

4. Système de batterie, comprenant une batterie haute tension avec une pluralité de cellules de batterie (12) selon l'une des revendications précédentes interconnectées les unes aux autres via leurs bornes de cellule (14, 16).

5. Système de batterie (10) selon la revendication 4, dans lequel le système de batterie comprend des moyens adaptés pour mesurer une température intérieure d'au moins l'une des cellules de batterie (12) en appliquant, via des moyens d'application d'un courant, un courant à travers la thermistance (18) via la borne de cellule (14) à laquelle la thermistance (18) est connectée et le moyen de connexion (20), le système de batterie comprenant des moyens de mesure de la chute de tension dans la thermistance (18), en déterminant la résistance de la thermistance (18) à partir de la chute de tension, en déterminant la température sur la base de la résistance déterminée.

6. Système de batterie (10) selon la revendication 4 ou 5, dans lequel le système de batterie (10) comprend des moyens adaptés pour mesurer une tension de cellule d'au moins l'une des cellules de batterie (12) via le moyen de connexion (20).

7. Système de batterie (10) selon l'une des revendications 4 à 6, dans lequel le système de batterie (10) comprend des moyens adaptés pour déterminer si un court-circuit à l'intérieur du système de batterie (10) s'est produit en surveillant, via des moyens de surveillance, les potentiels des boîtiers de cellule (13) de la pluralité de cellules de batterie (12) via leurs moyens de connexion (20) respectifs.

8. Véhicule électrique comprenant un système de batterie (10) selon l'une quelconque des revendications 4 à 7.
